# EUROPEAN PATENT APPLICATION

(11) **EP 4 376 064 A1**
(43) Date of publication of application: **29.05.2024**
(21) Application number: 22306743.0
(22) Date of filing: 25.11.2022
(51) Int. Cl.: H01L 21/78

(54) **A METHOD FOR OBTAINING AN INTEGRATED DEVICE COMPRISING USING AN ETCHING MASK TO DEFINE DICING LINES**

(71) Applicant: Murata Manufacturing Co., Ltd., Nagaokakyo-shi, Kyoto 617-8555 (JP)
(72) Inventor: LALLEMAND, Florent, 14200 HEROUVILLE SAINT-CLAIR (FR); LE CORNEC, François, 14000 CAEN (FR); LEMENAGER, Maxime, 14000 CAEN (FR); TANAY, Florent, 14650 CARPIQUET (FR)
(74) Representative: Cabinet Beau de Loménie

(57) **Abstract**

A method for obtaining an integrated device comprising:
forming a metal barrier layer (102) above a substrate,
forming an anodizable metal layer on the metal barrier layer,
anodizing a first region and a second region of the anodizable metal layer to obtain respectively a first porous region (PRA) and a second porous region (PRB) both comprising a plurality of substantially straight pores (105) that extend from a top surface of the porous region, perpendicularly to the top surface of the porous region, towards the metal barrier layer,
forming an etching mask (107) above at least the first porous region (PRA) having an opening (OP) above the second porous region,
etching the bottom ends of pores of the second porous region through the opening of the etching mask to obtain pores that form a device region, and pores in the first porous region that form a dicing line, the integrated device being delimited at least by the dicing line.

## Description

### Field of the Invention

The present invention relates to the field of integration and, more particularly, to electrical devices, related semiconductor products, and their methods of manufacture.

### Technical Background

Electronic components such as capacitors may be integrated into semiconductor products in a variety of forms. For example, planar capacitors may be formed above semiconductor substrates by forming two planar electrodes separated by a dielectric layer. However planar capacitors provide low capacitance density, this implies that a high value capacitance will consume a significant area of silicon.

To overcome this issue, it has been proposed to form three-dimensional structures to increase the capacitance of capacitors. Capacitance densities of the order of a Farad per m² have been achieved using three-dimensional (3D) capacitors.

A 3D capacitor comprises functional electrodes presenting a relief (for example they comprise a surface presenting a relief or they are formed on a relief such as a pore, a hole, a trench, or a pillar). Typically, it is possible to form a conductive 3D structure by using Deep Reactive Ion Etching, followed by subsequent deposition steps of a dielectric and of a conductive material to form a capacitor. Document WO 2007125510 discloses a method for forming such a 3D capacitor.

It has also been proposed to form capacitors inside of a porous insulating structure formed by anodizing a conductive layer, such a structure being disclosed in document WO 2015/063420.

Integrated devices that include such porous structures may also include porous structures along their periphery, i.e. where a mechanical blade has been used to dice a plurality of integrated devices formed on a same substrate. The use of a mechanical blade has been observed to produce irregular jagged edges at the level of the porous structures.

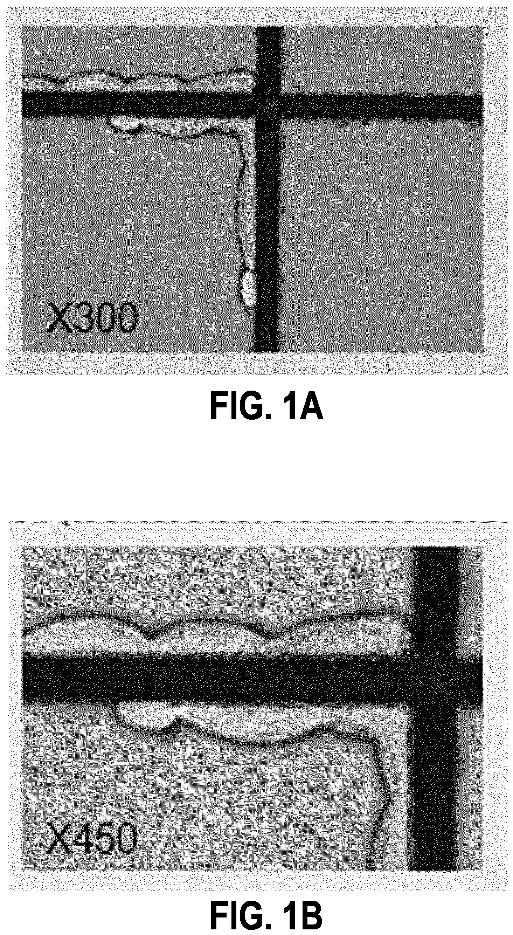

Figure 1A and 1B are images acquired with different magnifications of a portion of a wafer including multiple integrated devices that have been diced. As can be observed on the figures, the edges of the integrated devices (where the blade went through) are jagged and irregular.

The inventors of the present inventions have observed that the jagged and irregular edges result from chips of porous material splintering of the substrate when the blade passes through.

It is desirable to avoid these defects as they may degrade the mechanical properties of the integrated devices after dicing.

Overcoming this defect has been performed by performing a laser grooving prior to a mechanical blade dicing. This solution is not satisfactory as it requires the implementation of an additional process step. Other drawbacks of this solution include the cost, the duration, and the damages that the laser can do to the integrated circuits in the vicinity of the grooved area. In fact, the laser heat can weaken the underlying materials down to the substrate (for example silicon), which degrades the mechanical properties of the dies after dicing. In fact, other types of defects with chips of materials being splintered have been observed to occur when using laser grooving.

There is a need for a solution that avoids the appearance of chips being splintered off, which is less time consuming and with a limited number of additional process steps.

Also, it should be noted that it is not desirable to leave the anodizable material in the dicing lines. For example, if aluminum is used, a mechanical blade could get stuck when dicing a thick aluminum layer. Porous material is easier to dice through.

The present invention has been made in the light of the above problems.

### Summary of the Invention

The present invention provides a method for obtaining an integrated device comprising:
forming a metal barrier layer above a substrate,
forming an anodizable metal layer on the metal barrier layer,
anodizing a first region and a second region of the anodizable metal layer to obtain respectively a first porous region and a second porous region both comprising a plurality of substantially straight pores that extend from a top surface of the porous region, perpendicularly to the top surface of the porous region, towards the metal barrier layer,
forming an etching mask (for example a hard mask) above at least the first porous region having an opening above the second porous region,
etching the bottom ends of pores of the second porous region through the opening of the etching mask to obtain pores that form a device region, and pores in the first porous region that form a dicing line, the integrated device being delimited (in the plane horizontal plane, for example the plane in which the layers extend) at least by the dicing line.

Obtaining the integrated device can also comprise additional steps to obtain a structure to be diced through at least the dicing line (for example making a component). Also, the integrated device can substantially coincide with the device region. The device region can accommodate a component such as a capacitor, a resistor, or an inductor. In fact, the device region will be identified by the person skilled in the art as the central region of an integrated device, capable of accommodating components.

A dicing line can also be identified by the person skilled in the art as the portion along at least an edge or all the edges of the integrated device. Typically, dicing lines are arranged in a grid delimiting multiple integrated devices (for example, here, the dicing line delimits and therefore surrounds the integrated device).

The above method has been observed to limit the appearance of defects such as the ones described in relation to figures 1A and 1B.

In the above method, the substrate can comprise a stack of different materials, for example a semiconductor layer (typically a silicon or glass wafer) and a conductive layer (for example including the anodizable material). In this arrangement, the conductive layer can be the top layer in the substrate, for example in contact with the metal barrier layer.

As a metal barrier is used to prevent anodization of the underlying substrate (which may include anodizable material), the anodization process creates an oxide of the material of the barrier layer at the bottom ends of the pores, which may subsequently prevent the anodization fluid and the pores from progressing into the underlying substrate. As it may be desirable to have components formed in the device region that form conductive structures that extend inside the pores and are electrically connected to the barrier layer, the oxide plug at the bottom of the pores is usually removed in an etching step. This etching step is performed by means of an etching mask (sometimes referred to as a hard mask) that delimits the components in a device region. It should be noted that the device region comprises pores that open onto the metal barrier layer, to allow forming a device electrically connected to the barrier layer.

The inventors of the present invention have observed that when this etching mask covers the pores where a mechanical blade will be used to dice the integrated circuit, the appearance of splintered chips is prevented during a subsequent dicing step. This results from the presence of oxide plugs at the bottom of pores in the dicing area, the oxide plugs acting as anchoring points between the anodic porous oxide and the metal barrier layer. Delamination of the anodic porous oxide in the form of chips is prevented.

Here, the dicing line in which the bottom ends of pores have not been etched will benefit from the presence of oxide plugs. Another advantage of the method lies in the visual aspect of portions in which pores include oxide plugs: these pores have a tint that differs from the tint of portions in which these plugs have been removed. This facilitates ensuring that the oxide plugs have been duly removed from the bottom ends of the pores in the regions in which devices should be made. It should be noted that without this different visual aspect, confirming that the oxide plugs have been removed cannot be performed.

The person skilled in the art will be able to select the materials of the metal barrier layer and of the metal to be anodized so as to form the straight pores. Also, the anodization mask has a material to be selected so as not to be affected when the bottom ends of the pores are etched.

Etching the bottom ends of the pores can comprise reaching the metal barrier layer, for example by removing an oxide plug.

According to a particular embodiment, the method comprises dicing the structure to be diced through at least the dicing line to obtain a diced integrated device.

Prior to the dicing, the integrated device, although finished, is attached at its sides to other integrated devices which have been formed along with the integrated device to be diced.

Dicing is performed in the porous portion, around the second porous portion.

According to a particular embodiment, dicing comprises performing a mechanical blade dicing.

In particular, this embodiment may be implemented without the use of a laser grooving method. For example, dicing is performed using only the mechanical blade dicing. Consequently, fewer manufacturing steps are required and the defects associated with using laser grooving are avoided.

According to a particular embodiment, the bottom ends of the pores (for example all the pores of the porous region that reach the metal barrier layer) are plugged up by an oxide plug of the metal barrier layer (the material of the oxide plug is an oxide of the metal of the barrier layer), and wherein etching the bottom ends of pores of the second porous region through the opening of the etching mask comprises removing the oxide plug of the pores accessible through the opening (i.e. the pores of the second porous portion).

Thus, in the device region, there is a set of pores that do not comprise an oxide plug at their bottom ends, the pores (or a fraction of these pores) that are accessible through the opening.

According to a particular embodiment, the method comprises forming an anodization mask (also called a hard mask) having at least one anodization opening delimiting the first porous region and the second porous region (there can be a single opening for both regions, one opening for each porous region, or more than two openings for the two porous regions which may include sub regions).

In this particular embodiment, an anodization mask (sometimes referred to as a hard mask) is formed. This mask remains in place under the etching hard mask, and the opening of the etching mask is located within the at least one opening of the anodization mask. The anodization mask may typically include an opening for the first porous region and for the second porous region where a component may be formed inside the integrated device.

According to a particular embodiment, the anodization mask has a first opening delimiting the first porous region and a second opening, separate from the first opening, delimiting the second porous region.

According to a particular embodiment, the method comprises depositing a stacked structure including a bottom electrode layer, a dielectric layer, and a top electrode layer inside a group of pores of the device region so as to form a capacitor of the integrated device.

This particular embodiment comprises forming a capacitor of the integrated device. Forming the capacitor may be performed after the etching step (of the bottom ends of the pores) has been performed and before a subsequent dicing step.

It should be noted that the group of pores can include all the pores accessible through the opening (in that case only one capacitor is formed). Alternatively, the group of pores only includes a fraction of the pores accessible through the opening, so that the integrated device can comprise an additional component along with the capacitor. For example, if the integrated device comprises multiple components, these components can be formed in a plurality of openings that form the second opening and the second porous region.

The invention is not limited to integrated device comprising capacitors, other components can be formed in the device region such as resistors, inductors, sensors, etc.

According to a particular embodiment, the first porous region surrounds the second porous region.

This particular embodiment allows ensuring that the dicing lines that surround the integrated device, typically in the shape of a rectangle, include pores that have an oxide plug at their bottom end, so that the dicing leads to a cleaner output.

According to a particular embodiment, the method comprises forming a passivation layer above the etching mask having an opening at the level of the dicing line.

Integrated devices can be covered by a passivation layer and it has been observed that removing this layer at the level of the dicing line (for example by patterning the passivation layer) leads to an improved dicing.

According to a particular embodiment, a plurality of integrated devices is obtained, the integrated devices being delimited by dicing lines arranged in a grid.

For example, the method includes forming a single metal barrier layer above the substrate that will be used to support all the devices before their dicing. This single metal barrier may be patterned.

For example, the method includes forming a single anodizable metal layer for all the devices.

For example, the method includes a single anodizing step to obtain a porous region (for example a region where the dicing lines will be and inside where each device will be).

For example, the method includes forming a single etching mask above a portion of the porous region having a grid-shape to define a plurality of device regions, the etching mask having an opening inside each device region that opens onto another portion of the porous region of each device region.

For example, the method includes etching the bottom ends of pores through the openings of each device region to obtain a structure to be diced delimiting the integrated devices.

The invention also provides an integrated device comprising:
a substrate,
a metal barrier layer above the substrate,
a layer including a first porous region of anodized metal and a second porous region both comprising a plurality of substantially straight pores that extend from a top surface of the porous region, perpendicularly to the top surface of the porous region, towards the metal barrier layer,
wherein the bottom ends of pores of the first porous region are plugged up by an oxide plug of the metal barrier, the bottom ends of pores of the second porous region are etched and reach the metal barrier so as to form a device region,
and wherein pores in the first porous region form a dicing line.

This integrated device can be configured to implement all the embodiments of the method as defined above.

According to a particular embodiment, the device comprises an etching mask above at least the first porous region having an opening above the second porous region, wherein the bottom ends of pores of the second porous region accessible through the opening are plugged up by the oxide plug of the metal barrier.

According to a particular embodiment, the first porous region surrounds the second porous region.

According to a particular embodiment, the device comprises a stacked structure including a bottom electrode layer, a dielectric layer, and a top electrode layer inside a group of pores of the device region so as to form a capacitor of the integrated device.

According to a particular embodiment, the integrated device is diced.

For example, it is not attached to another integrated device.

### Brief Description of the Drawings

Further features and advantages of the present invention will become apparent from the following description of certain embodiments thereof, given by way of illustration only, not limitation, with reference to the accompanying drawings in which:
- figures 1A and 1B, already described, show jagged and irregular edges,
- figure 2 is a cross-section of base structure,
- figure 3 is a cross-section of the base structure of figure 2 after an etching step has been performed
- figure 4 is a cross-section of the structure of figure 3 after a capacitor has been formed,
- figure 5 is a cross-section of the structure of figure 4 after an additional opening has been formed,
- figure 6 is a top view of a structure to be diced,
- figure 7 is a cross-section of a diced structure,
- figure 8 is a top view of an integrated device, and
- figures 9A and 9B show clean edges.

### Detailed Description of Example Embodiments

We will now describe method for obtaining an integrated device. The present method is particularly adapted for integrated devices that include porous regions made of porous anodized metal, that accommodate components that take advantage of the very high surface area obtained on the walls of the pores such as capacitors. The invention is not limited to devices including capacitors as other devices can be formed inside the pores of a porous region (resistor, inductor).

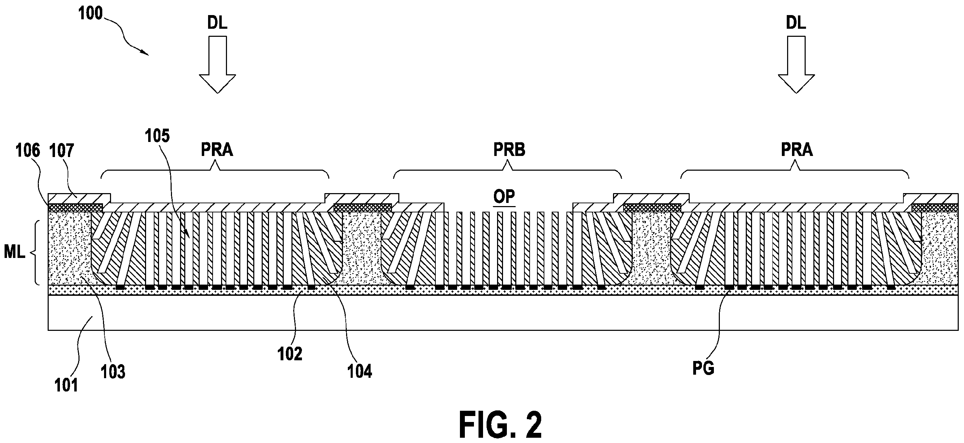

Figure 2 shows a base structure 100 from which an integrated circuit will be obtained.

On this figure, a substrate 101 is used to support the integrated circuit. The substrate 101 can comprise a semiconductor substrate (for example a silicon substrate) or a substrate comprising glass or a polymer material. The substrate 101 may also include a conductive layer, for example comprising aluminum, for example located at the top (on the figure) of the substrate.

Above the substrate (for example above a conductive layer of the substrate), a metal barrier layer 102 has been formed. This barrier layer is an anodization barrier layer and can comprise tungsten, titanium (Ti), or tantalum (Ta).

An anodizable metal layer is formed on the metal barrier layer. The material of this anodizable metal layer is selected so as to be able to produce, during an anodization, straight pores that extend substantially perpendicularly from a surface exposed to the anodization fluid (the top surface on the figure). In the present description and by way of example, the anodizable metal layer comprises aluminum (alternatively, the anodizable metal layer may also comprise other metals such as titanium or tantalum). By way of example, the aluminum layer can have a thickness from several to tens of micrometers.

On the figure, a selective anodizing process has been performed to obtain layer ML that comprises aluminum portions 103 (portions that have not been anodized) and anodic oxide portions 104 (anodic oxide of aluminum). In the anodic oxide portions, pores 105 have been formed and these pores are substantially straight pores that extend from a top surface of the porous region, perpendicularly to the top surface of the porous region, towards the metal barrier layer.

Here, pores that reach the metal barrier layer 102 are plugged at their bottom end by an oxide plug PG comprising an oxide of the material of the metal barrier layer.

In order to obtain a selective etching, an anodization mask 106 has been formed and patterned above the anodizable metal layer, with openings defining several portions of the porous region. More precisely, a first porous region PRA is obtained around a second porous region PRB. Delimiting the area to be anodized can be performed by means of a hard mask/an anodization mask using the method disclosed in application WO 2019/202046.

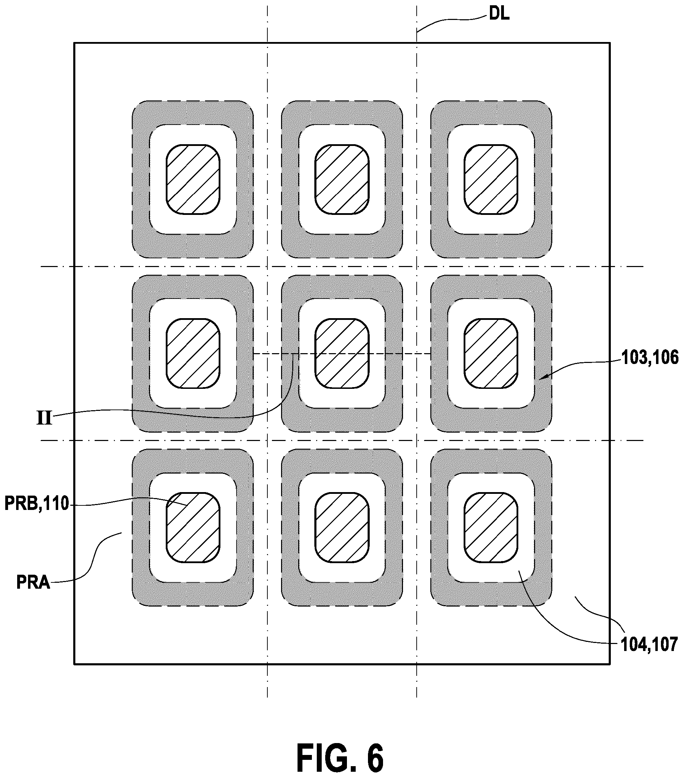

In the illustrated example, the first porous region PRA completely surrounds the second porous region PRB, as will appear on figure 6 (top view). The invention is not limited to a complete surrounding and also covers partial surroundings, for example with the first porous region being arranged only on one side of the second porous region.

Also, in the illustrated example, the first porous region PRA is separate from the second porous region PRB as portions of unanodized metal 103 separate the first and the second porous region. The two porous regions can also be contiguous, formed in a single opening of an anodization mask (with no unanodized metal being left between the two regions).

Subsequently, an etching mask 107 has been deposited above the structure to cover the pores of the first porous region but with an opening OP above a portion of the second porous region PRB. More precisely, the opening OP opens onto the middle portion of the second porous region, so as to only open onto straight pores that reach the metal barrier layer 102.

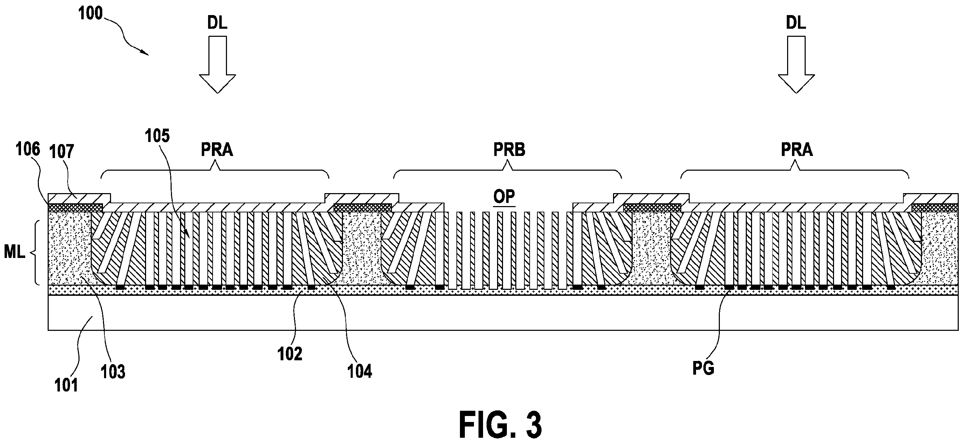

Subsequently, an etching can be performed inside the pores accessible through the opening OP, to remove the oxide plugs formed at the bottom of the pores 105 (as shown on figure 3, where removing the oxide plugs leaves a recess in the tungsten). For example, if a capacitor structure is formed inside the pores, the bottom electrode will be in electrical contact with the metal barrier layer because the oxide has been removed (and a conductive layer if one is present below the metal barrier layer).

As there is no opening of the etching mask above the porous portion PRA surrounding the second porous portion PRB, consequently, no etching of the oxide plugs is performed in this porous portion.

Forming the etching mask to cover the pores of the portion PRA defines dicing lines DL that surround a device region (i.e. a region in which an integrated device will be obtained).

The inventors of the present invention have observed that the presence of oxide plugs increases the adhesion of porous material to a layer of metal barrier. Consequently, when a blade passes through, the porous material is not splintered.

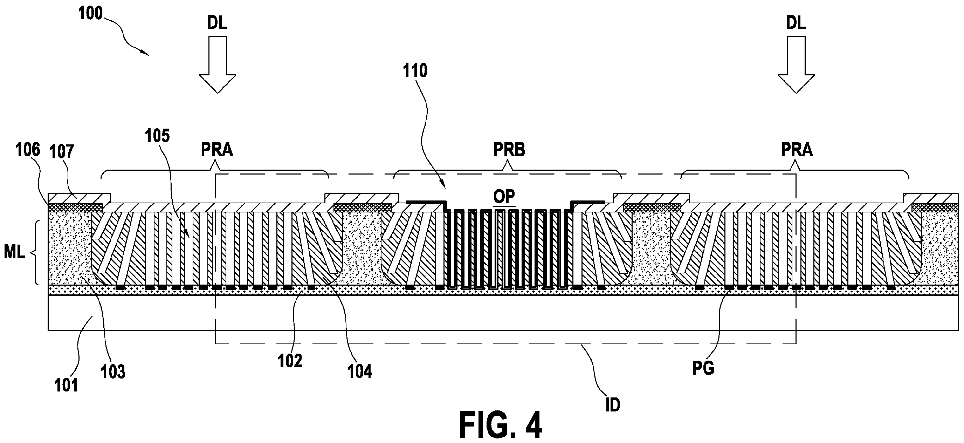

Figure 4 shows the structure of figure 3 after a capacitor 110 has been formed by depositing a stacked structure including a bottom electrode layer, a dielectric layer, and a top electrode layer inside the pores of the second porous portion accessible through the opening OP (and also above a portion of the etching mask 107). Depositing the layers of the stacked structure can be performed using ALD processes, or other methods that deposit material in a conformal manner (so as to conform to the shape of the pores)

The bottom electrode of the capacitor 110 is in electrical contact with the metal barrier layer 102 as the oxide plugs have been removed.

At this stage, a structure to be diced delimiting an integrated device ID is obtained (although still not diced, at this stage, it is considered that the integrated device is obtained as its main component has been formed; for other integrated devices, other device components can be formed).

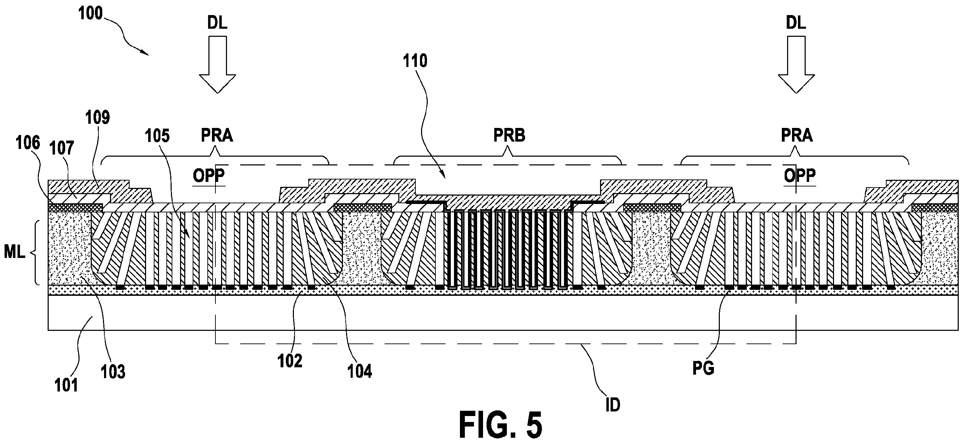

Figure 5 shows the device of figure 4 after a top passivation layer 109 has been formed. The passivation layer 109 comprises an opening OPP at the level of the dicing line to facilitate the dicing.

It should be noted that below layer 109, additional interconnection levels can be formed (metal layers and insulating layers in between). These levels are not represented on the figure for the sake of simplicity.

Figure 6 shows a structure observed from the top with multiple integrated devices formed using the steps described in reference to figures 2 to 5. In fact, the structure represented on figure 5 is a cross section along line II represented on figure 6. The same references are used to designate the same elements on figures 2 to 5, and 6. In particular, the grayed out portions correspond to un-anodized material covered by the anodization mask 106 and comprising aluminum 103. The hatched portions correspond to the device regions including capacitors 110. Clear portions correspond to porous material covered by the etching mask 107, and include the dicing lines DL (and also the periphery of each capacitor, inside each aluminum portion).

The structure of figure 6 can be part of a larger wafer (for example a silicon substrate having a wafer shape has been used). As can be observed on the figures, the dicing lines are arranged in a grid to delimit a plurality of integrated devices. The dicing lines go through portions where the etching mask is present, and consequently the dicing lines go through the first porous region with pores that include, at their bottom ends oxide plugs. This results in avoiding splintered chips of anodic porous oxide when performing a mechanical blade dicing.

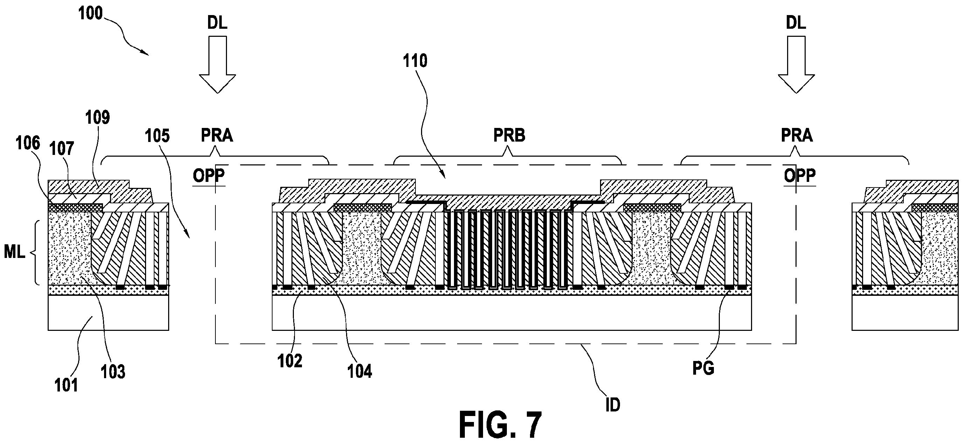

Figure 7 shows the structure of figure 5 after a mechanical blade dicing has been performed without performing a laser grooving. The integrated device ID is now a diced integrated device. The etching hard mask is accessible around the entire periphery of the integrated device.

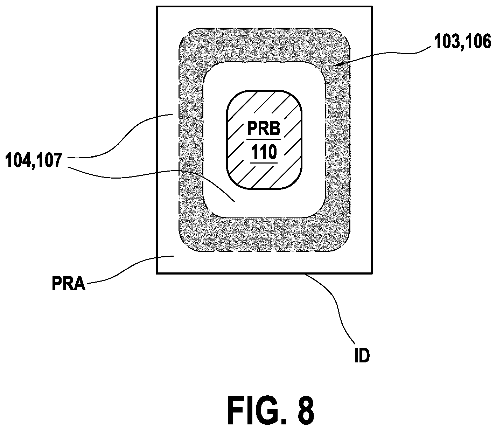

Figure 8 is a top-view of a diced device.

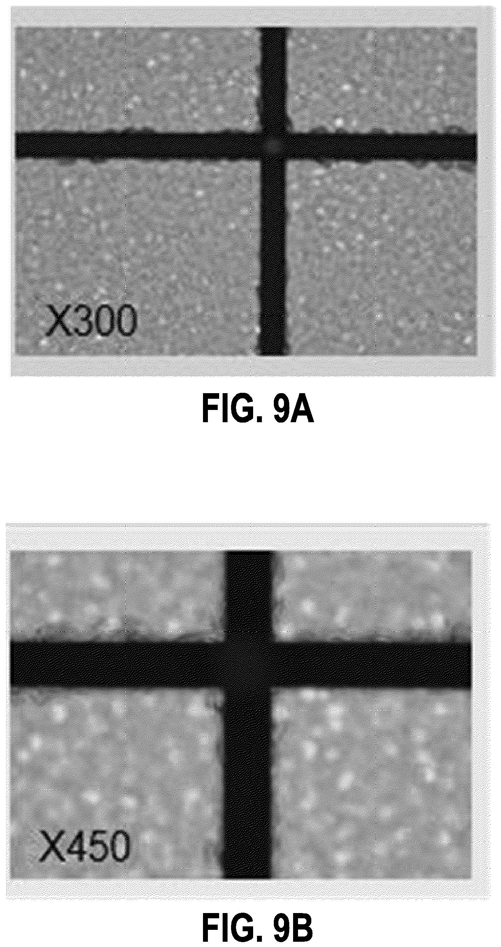

Figure 9A and 9B are images acquired with different magnifications of a portion of a wafer including multiple integrated devices that have been diced in accordance with the method described in reference to figures 2 to 8. As can be observed on the figures, the edges of the integrated devices (where the blade went through) are straight and regular, and this results from the presence of oxide plugs at the bottom of the pores.

## Claims

1. A method for obtaining an integrated device comprising:
forming a metal barrier layer (102) above a substrate,
forming an anodizable metal layer on the metal barrier layer,
anodizing a first region and a second region of the anodizable metal layer to obtain respectively a first porous region (PRA) and a second porous region (PRB) both comprising a plurality of substantially straight pores (105) that extend from a top surface of the porous region, perpendicularly to the top surface of the porous region, towards the metal barrier layer,
forming an etching mask (107) above at least the first porous region(PRA) having an opening (OP) above the second porous region,
etching the bottom ends of pores of the second porous region through the opening of the etching mask to obtain pores that form a device region, and pores in the first porous region that form a dicing line, the integrated device being delimited at least by the dicing line.

2. The method of claim 1, further comprising dicing the structure to be diced through at least the dicing line to obtain a diced integrated device.

3. The method of claim 2, wherein dicing comprises performing a mechanical blade dicing.

4. The method of any one of claims 1 to 3, wherein the bottom ends of the pores are plugged up by an oxide plug (PG) of the metal barrier layer, and wherein etching the bottom ends of pores of the second porous region through the opening of the etching mask comprises removing the oxide plug of the pores accessible through the opening.

5. The method of any one of claims 1 to 4, comprising forming an anodization mask (106) having at least one anodization opening delimiting the first porous region and the second porous region.

6. The method of claim 5, wherein the anodization mask has a first opening delimiting the first porous region and a second opening, separate from the first opening, delimiting the second porous region.

7. The method of any one of claims 1 to 6, comprising depositing a stacked structure including a bottom electrode layer, a dielectric layer, and a top electrode layer inside a group of pores of the device region so as to form a capacitor of the integrated device.

8. The method of any one of claims 1 to 7, wherein the first porous region surrounds the second porous region.

9. The method of any one of claims 1 to 8, comprising forming a passivation layer above the etching mask having an opening at the level of the dicing line.

10. The method of any one of claims 1 to 9, wherein a plurality of integrated devices is obtained, the integrated devices being delimited by dicing lines arranged in a grid.

11. An integrated device comprising:
a substrate (101),
a metal barrier layer (102) above the substrate,
a layer (ML) including a first porous region of anodized metal (PRA) and a second porous region (PRB) both comprising a plurality of substantially straight pores (105) that extend from a top surface of the porous region, perpendicularly to the top surface of the porous region, towards the metal barrier layer,
wherein the bottom ends of pores of the first porous region are plugged up by an oxide plug of the metal barrier, the bottom ends of pores of the second porous region are etched and reach the metal barrier so as to form a device region,
and wherein pores in the first porous region form a dicing line.

12. The device of claim 10, comprising an etching mask (106) above at least the first porous region having an opening above the second porous region, wherein the bottom ends of pores of the second porous region accessible through the opening are plugged up by the oxide plug of the metal barrier.

13. The device of claim 11 or 12, wherein the first porous region surrounds the second porous region.

14. The device of any one of claims 11 to 13, comprising a stacked structure including a bottom electrode layer, a dielectric layer, and a top electrode layer inside a group of pores of the device region so as to form a capacitor of the integrated device.

15. The device of any one of claims 11 to 14, wherein the integrated device is diced.
